# EUROPÄISCHE PATENTSCHRIFT

(11) **EP 2 686 371 B1**
(45) Veröffentlichungstag und Bekanntmachung des Hinweises auf die Patenterteilung: **21.11.2018**
(21) Anmeldenummer: 12712238.0
(22) Anmeldetag: 14.03.2012
(51) Int. Cl.: C08J 7/12, B29C 59/14

(54) **VERFAHREN ZUR MODIFIZIERUNG EINER OBERFLÄCHE EINES SUBSTRATS DURCH IONENBESCHUSS**
METHOD FOR MODIFYING A SURFACE OF A SUBSTRATE USING ION BOMBARDMENT
PROCÉDÉ DE MODIFICATION D'UNE SURFACE D'UN SUBSTRAT PAR BOMBARDEMENT IONIQUE

(30) Priorität: 14.03.2011 DE 102011013822
(43) Veröffentlichungstag der Anmeldung: 22.01.2014
(73) Patentinhaber: Fraunhofer-Gesellschaft zur Förderung der angewandten Forschung e.V., 80686 München (DE); Southwall Europe GmbH, 01900 Großröhrsdorf (DE)
(72) Erfinder: SCHULZ, Ulrike, 07751 Jena (DE); MUNZERT, Peter, 07743 Jena (DE); THIELSCH, Roland, 01189 Dresden (DE); SCHÖNBERGER, Waldemar, 01109 Dresden (DE); FAHLAND, Matthias, 01257 Dresden (DE); KLEINHEMPEL, Ronny, 09423 Gelenau (DE)
(74) Vertreter: Epping - Hermann - Fischer
(86) Internationale Anmeldenummer: PCT/EP2012/054480
(87) Internationale Veröffentlichungsnummer: WO 2012/123503

(56) Entgegenhaltungen:
- DE-U1-202006 017 024
- US-A1- 2005 233 083
- SCHULZ U: "REVIEW OF MODERN TECHNIQUES TO GENERATE ANTIREFLECTIVE PROPERTIES ON THERMOPLASTIC POLYMERS", APPLIED OPTICS, OPTICAL SOCIETY OF AMERICA, WASHINGTON, DC; US, Bd. 45, Nr. 7, 1. März 2006 (2006-03-01), Seiten 1608-1618, XP001239249, ISSN: 0003-6935, DOI: 10.1364/AO.45.001608

## Beschreibung

Die Erfindung betrifft ein Verfahren zur Modifizierung einer Oberfläche eines Substrats durch Ionenbeschuss, mit dem insbesondere eine reflexionsmindernde Oberflächenstruktur an Polymeroberflächen erzeugt werden kann.

Aus der Druckschrift WO 97/48992 ist bekannt, die Grenzflächenreflexion einer Oberfläche eines Polymersubstrats durch Aufbringen eines Interferenzschichtsystems aus mehreren dünnen transparenten Schichten zu vermindern. Derartige Interferenzschichtsysteme werden in der Regel durch Vakuumbeschichtungsverfahren aufgebracht, wobei die Anwendung auf großflächige Polymersubstrate aufgrund der hohen Anforderungen an die Schichtdickengenauigkeit technisch aufwändig ist. Weiterhin ist es bei Substraten aus Polymeren schwierig, eine ausreichende Haftung des Interferenzschichtsystems, das in der Regel aus oxidischen Materialien gebildet wird, zu gewährleisten.
Eine alternative Möglichkeit zur Verminderung der Grenzflächenreflexion eines Substrats aus einem Polymer wird in der Druckschrift DE 10241708 B4 beschrieben. Bei diesem Verfahren wird an der Oberfläche des Polymersubstrats durch einen Ionenbeschuss mit einem Ionenstrahl eine Brechzahlgradientenschicht erzeugt, welche die Grenzflächenreflexion der Oberfläche des Polymers vermindert. Die vorgeschlagene Behandlung der Polymeroberfläche mit einem Ionenstrahl ist aber nicht ohne Weiteres auf großflächige Substrate wie beispielsweise Polymerfolien anwendbar.

Die Druckschrift DE 43 08 633 A1 beschreibt ein Verfahren zur Behandlung von Kunststofffolien mit einem von einer Glimmkathode erzeugten Niederdruckplasma, wobei als Prozessgas Argon, Chlor, Fluor oder Sauerstoff oder ein Gemisch aus Argon und Sauerstoff verwendet wird, und wobei die Glimmkathode mit dem negativen Pol einer Gleichspannungsquelle verbunden ist.

Der Erfindung liegt die Aufgabe zugrunde, ein Verfahren zur Modifizierung einer Oberfläche eines Polymersubstrats durch Ionenbeschuss anzugeben, mit dem insbesondere eine reduzierte Grenzflächenreflexion des Substrats erzielt werden kann, wobei das Verfahren zur Behandlung großer Flächen geeignet sein soll. Insbesondere soll das Verfahren in einem so genannten Rolle-zu-Rolle-Prozess anwendbar sein, bei dem das Substrat beispielsweise in Form einer Folie von einer Rolle abgewickelt und auf eine andere Rolle aufgewickelt wird, und auf diese Weise vorzugsweise kontinuierlich durch die zur Behandlung der Oberfläche vorgesehene Vakuumanlage transportiert wird.

Diese Aufgabe wird durch ein Verfahren zur Modifizierung einer Oberfläche eines Polymersubstrats gemäß Patentanspruch 1 gelöst. Vorteilhafte Ausgestaltungen und Weiterbildungen der Erfindung sind Gegenstand der abhängigen Ansprüche.

Bei dem Verfahren zur Modifizierung einer Oberfläche eines Polymersubstrats durch Ionenbeschuss werden die Ionen mittels einer magnetfeldunterstützten Glimmentladung in einem Prozessgas erzeugt. Die magnetfeldunterstützte Glimmentladung wird mittels eines Magnetrons erzeugt, das eine Elektrode und mindestens einen Magneten zur Erzeugung des Magnetfelds aufweist.

Derartige Magnetrons sind an sich bekannt und werden beispielsweise in Magnetron-Sputteranlagen zur Abscheidung dünner Schichten eingesetzt. Das hierin beschriebene Verfahren kann daher vorteilhaft in bestehende Vakuumbeschichtungsanlagen implementiert werden.

Beim herkömmlichen Magnetronsputtern wird mittels des Magnetrons ein Plasma erzeugt, wobei als Prozessgas typischerweise ein Edelgas, insbesondere Argon, verwendet wird. Beim Magnetronsputtern werden in dem Plasma erzeugte positive Ionen zur Elektrode beschleunigt, die daher auch als Target bezeichnet wird. Die auf die Elektrode auftreffenden Ionen schlagen dort Atome des Elektrodenmaterials heraus, die auf dem Substrat abgeschieden werden.

Im Gegensatz zu dem an sich bekannten Magnetronsputtern wird bei dem hierin beschriebenen Verfahren ein Prozessgas eingesetzt, das mindestens einen elektronegativen Bestandteil aufweist, sodass bei der magnetfeldunterstützten Glimmentladung negative Ionen erzeugt werden.

Zumindest ein Teil der negativen Ionen wird dabei an der Oberfläche der Elektrode erzeugt und durch eine an die Elektrode angelegte elektrische Spannung in Richtung des Substrats beschleunigt. Vorzugsweise werden die negativen Ionen von der Elektrode derart beschleunigt, dass sie mit einer Energie von mindestens 100 eV auf das Substrat auftreffen.

Die auf das Substrat auftreffenden negativen Ionen bewirken dort eine Modifizierung der Oberfläche. Insbesondere kann auf diese Weise eine reflexionsmindernde Oberflächenstruktur an der Oberfläche des Substrats erzeugt werden. Die auf die Oberfläche des Substrats auftreffenden Ionen können dort insbesondere einen Materialabtrag bewirken, durch die die Oberfläche des Substrats aufgeraut wird. Diese Aufrauung bewirkt einen Brechungsindexgradienten, durch den die Reflexion der Oberfläche vermindert wird. Es ist alternativ auch möglich, dass die auftreffenden Ionen in einen oberflächennahen Bereich des Substrats implantiert werden und auf diese Weise einen Dichte- und/oder Brechungsindexgradienten erzeugen.

Die Oberfläche des Substrats wird durch den Ionenbeschuss insbesondere aufgeraut, wobei mit dem Verfahren vorteilhaft vergleichsweise tiefe Strukturen erzeugt werden können. Bei einer vorteilhaften Ausgestaltung wird mittels des Ionenbeschusses eine Struktur an der Oberfläche des Substrats erzeugt, die sich mindestens 50 nm tief in das Substrat hinein erstreckt. Die Art der an der Oberfläche des Substrats erzeugten Strukturen lässt sich insbesondere durch eine Variation der Höhe und des zeitlichen Verlaufs der an die Elektrode des Magnetrons angelegten elektrischen Spannung variieren.

Die elektrische Spannung, die an die Elektrode zur Beschleunigung der negativen Ionen in Richtung des Substrats angelegt wird, ist eine Mittelfrequenz-Spannung. Es hat sich herausgestellt, dass die Verwendung einer Mittelfrequenz-Spannung die Bildung von negativen Ionen auf der Oberfläche der Elektrode begünstigt. Die Mittelfrequenz-Spannung weist bei dem Verfahren eine Frequenz zwischen 1 kHz und 250 kHz auf.

Neben der Erzielung einer reflexionsmindernden Wirkung auf Polymersubstraten lässt sich das Verfahren auch zur Aufrauung einer Oberfläche zu anderen Zwecken einsetzen. Ziel des Verfahrens kann beispielsweise eine Vergrößerung der spezifischen Oberfläche oder die Erhöhung des Absorptionskoeffizienten sein. Das Verfahren kann auf alle Substrate abgewandt werden, die effektiv durch elektronegative Ionen abgetragen werden können. Neben Kunststoffen trifft dies insbesondere auf Kohlenstoff zu.

Bei dem elektronegativen Bestandteil des Prozessgases handelt es sich bevorzugt um Sauerstoff. Bei einer weiteren vorteilhaften Ausgestaltung des Verfahrens wird als elektronegativer Bestandteil des Prozessgases Fluor oder Chlor verwendet. Die Verwendung von Sauerstoff, Fluor oder Chlor ist besonders vorteilhaft, da diese Materialien gemäß der Elektronegativitätsskala von Pauling die höchste Elektronegativität unter den chemischen Elementen aufweisen.

Die Elektrode des Magnetrons enthält vorzugsweise mindestens eines der Elemente Al, Mg, Si oder Ti oder besteht daraus. Die Elektrode kann auch eine Legierung, die mindestens eines dieser Elemente mit einem Gewichtsanteil von mindestens 10% aufweist, enthalten.

Bei dem Magnetron kann es sich beispielsweise um ein Planarmagnetron handeln. Bei einem Planarmagnetron ist die Elektrode im Wesentlichen eben ausgebildet, was nicht ausschließt, dass die dem Plasma zugewandte Oberfläche der Elektrode aufgrund eines Materialbetrags durch auftreffende Ionen nicht vollständig planar ist.

Bei einer bevorzugten Ausgestaltung weist das Magnetron mindestens zwei Planarmagnetrons auf. Beispielsweise können zwei Planarmagnetrons nebeneinander angeordnet sein und auf diese Weise ein Doppelmagnetron ausbilden. Dadurch können größere Substrate oder größere Teilflächen eines Substrats gleichzeitig behandelt werden. Weiterhin kann im Fall eines bewegten Substrats vorteilhaft die Durchlaufgeschwindigkeit erhöht werden.

Bei einer weiteren vorteilhaften Ausgestaltung ist das Magnetron ein Rohrmagnetron. Bei dieser Ausführung ist die Elektrode des Magnetrons in Form einer Röhre ausgeführt und wird vorteilhaft bei dem Verfahren um eine Drehachse der Röhre gedreht. Das Magnetsystem des Magnetrons wird dabei vorzugsweise nicht bewegt. Das stationäre Magnetfeld lokalisiert den Bereich, in dem die Glimmentladung stattfindet. In diesem Bereich werden die auf der Elektrode adsorbierten negativen Ionen in Richtung des Substrats beschleunigt. Durch die Drehung der Elektrode des Rohrmagnetrons werden kontinuierlich Bereiche der rohrförmigen Elektrode in den Bereich der Entladung rotiert, die adsorbierte Atome des elektronegativen Bestandteils des Prozessgases aufweisen. Auf diese Weise kann eine höhere Effizienz des Verfahrens als bei Verwendung eines Planarmagnetrons erzielt werden.

Bei einer vorteilhaften Ausgestaltung des Verfahrens weist das Magnetron mindestens zwei Rohrmagnetrons auf. Insbesondere kann das Magnetron ein Doppelmagnetron sein, das zwei Rohrmagnetrons aufweist. Dies ermöglicht die Behandlung großflächiger Substrate und/oder die Erhöhung der Durchlaufgeschwindigkeit eines bewegten Substrats.

Bei dem Verfahren wird an das Substrat keine elektrische Spannung angelegt. Insbesondere wird auch an einen eventuell verwendeten Substrathalter für das Substrat keine elektrische Spannung angelegt. Die Beschleunigung der negativen Ionen zum Substrat erfolgt also ausschließlich durch die an die Elektrode des Magnetrons angelegte Spannung. Das Verfahren ist daher insbesondere für elektrisch isolierende Substrate aus elektrisch isolierenden Polymeren geeignet.

Das Substrat ist bei dem Verfahren ein Polymersubstrat. Das Verfahren kann vorteilhaft für die Modifizierung der Oberfläche einer Vielzahl von Polymeren eingesetzt werden. Insbesondere kann das Substrat Polyethylenterephthalat (PET), Polycarbonat (PC), Polymethylmethacrylat (PMMA), Ethylen-Tetrafluorethylen (ETFE), Polyethylennaphthalat (PEN) oder Triacetylcellulose (TAC) aufweisen.

Weiterhin hat das Verfahren den Vorteil, dass die Oberflächenmodifizierung, insbesondere die Herstellung einer reflexionsmindernden Nanostruktur an der Oberfläche des Substrats, vergleichsweise schnell erzielt werden kann. Vorzugsweise wird die Oberfläche des Substrats nicht länger als 200 s mit den Ionen bestrahlt.

Das Verfahren kann vorteilhaft in einer Vakuumanlage betrieben werden, in der das Substrat während des Ionenbeschusses kontinuierlich bewegt wird. Vorzugsweise wird das Substrat während des Ionenbeschusses mit einer Geschwindigkeit von mindestens 1 m/min bewegt. Das Substrat wird beispielsweise während der Durchführung des Verfahrens mit einem Transportband bewegt. Das Verfahren kann insbesondere in einer als Bandbeschichtungsanlage vorgesehen Vakuumanlage durchgeführt werden.

Insbesondere können mit dem Verfahren großflächige Substrate wie beispielsweise Folien in einem Rolle-zu-Rolle-Verfahren behandelt werden. In diesem Fall wird das Substrat von einer Rolle abgewickelt und auf eine andere Rolle aufgewickelt und auf diese Weise kontinuierlich durch den bei dem Verfahren erzeugten Ionenstrahl bewegt.

Vorteilhaft wird mittels des Ionenbeschusses eine Struktur an der Oberfläche des Substrats erzeugt, die einen Brechungsindexgradienten in einer senkrecht zur Substratoberfläche verlaufenden Richtung erzeugt. Dies bedeutet, dass sich der Brechungsindex an der Grenzfläche zwischen dem Substrat und dem Umgebungsmedium aufgrund der an der Oberfläche des Substrats erzeugten Strukturierung nicht abrupt ändert, sondern einen kontinuierlichen Übergang ausbildet. Vorzugsweise erstreckt sich der Bereich des Brechungsindexgradienten in der Richtung senkrecht zur Oberfläche des Substrats über einen Bereich von mindestens 50 nm. Eine auf diese Weise mittels des Ionenbeschusses erzeugte Struktur vermindert insbesondere die Reflexion der Oberfläche des Substrats. Insbesondere ist das Verfahren daher dazu geeignet, die Oberfläche eines Substrats zu entspiegeln, wobei auch große Flächen, wie beispielsweise die Oberfläche einer Polymerfolie, vergleichsweise einfach und kostengünstig behandelt werden können.

Die Erfindung wird im Folgenden anhand von Ausführungsbeispielen im Zusammenhang mit den Figuren 1 bis 4 näher erläutert.

Es zeigen:
- Figur 1: eine schematische Darstellung eines Querschnitts durch eine Vorrichtung zur Durchführung des Verfahrens zur Modifizierung einer Oberfläche eines Substrats gemäß einem ersten Ausführungsbeispiel,
- Figur 2: eine schematische graphische Darstellung des zeitlichen Verlaufs der Spannung an der Elektrode bei einem Ausführungsbeispiel,
- Figur 3: eine schematische Darstellung eines Querschnitts durch eine an der Oberfläche des Substrats erzeugte Oberflächenstruktur bei einem Ausführungsbeispiel, und
- Figur 4: eine schematische Darstellung eines Querschnitts durch eine Vorrichtung zur Durchführung des Verfahrens zur Modifizierung einer Oberfläche eines Substrats gemäß einem zweiten Ausführungsbeispiel.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

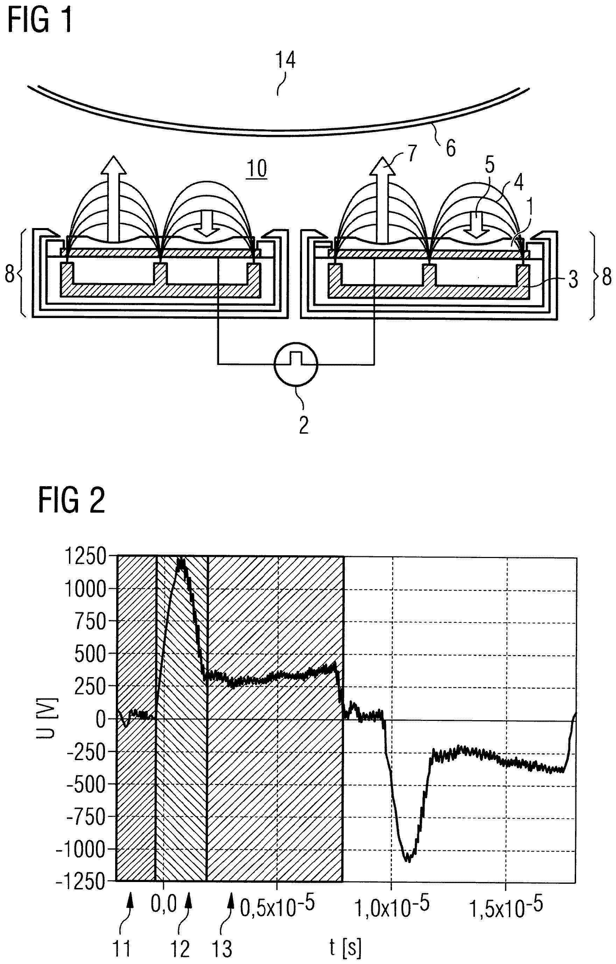

Die in Figur 1 dargestellte Vorrichtung zur Durchführung des Verfahrens zur Modifizierung der Oberfläche eines Substrats 6 weist eine Anordnung aus zwei Planarmagnetrons 8 auf. Die Planarmagnetrons 8 weisen jeweils eine Elektrode 1 auf, die an einen Mittelfrequenz-Spannungsgenerator 2 angeschlossen sind. Weiterhin enthalten die Planarmagnetrons 8 jeweils Magnete 3, die ein Magnetfeld 4 erzeugen.

Das Verfahren wird in einer Vakuumanlage durchgeführt, in das ein Prozessgas 10 eingelassen wird. Das Verfahren ist vorteilhaft zur Behandlung von großflächigen Substraten 6 geeignet. Beispielsweise kann das Substrat 6 in Form einer Folie auf einer Rolle 14 transportiert werden. Das Substrat 6 wird während der Durchführung des Verfahrens vorzugsweise kontinuierlich in einem Abstand an den Magnetrons 8 vorbei bewegt.

Mittels der Magnetrons 8 wird bei dem Verfahren eine magnetfeldunterstützte Glimmentladung in dem Prozessgas 10 erzeugt. Dabei wird in dem Prozessgas 10 ein Plasma erzeugt, wobei die von den Magneten 3 erzeugten Magnetfelder 4 eine Diffusion von Elektronen aus dem Plasma vermindern sollen.

Bei der magnetfeldunterstützten Glimmentladung werden in dem Prozessgas 10 zum einen positive Ionen 5 erzeugt, die in Richtung der Elektroden 1 beschleunigt werden. Bei den positiven Ionen 5 handelt es sich beispielsweise um Ionen eines Edelgases, das in dem Prozessgas 10 enthalten ist. Das Prozessgas 10 kann beispielsweise Argon enthalten.

Bei dem hierin beschriebenen Verfahren enthält das Prozessgas 10 mindestens einen elektronegativen Bestandteil. Bei dem elektronegativen Bestandteil handelt es sich bevorzugt um Sauerstoff. Alternativ kann das Prozessgas 10 beispielsweise auch Fluor oder Chlor als elektronegativen Bestandteil enthalten. Sauerstoff, Fluor und Chlor zeichnen sich durch besonders hohe Werte der Elektronegativität aus. Dadurch, dass das Prozessgas 10 mindestens einen elektronegativen Bestandteil enthält, entstehen bei der magnetfeldunterstützten Glimmentladung negative Ionen 7. Ein Teil der negativen Ionen wird im Plasma gebildet. Diese negativen Ionen haben in der Regel relativ niedrige Energien und können daher in der Regel das Plasma nicht verlassen. Weitere negative Ionen 7 werden an der Oberfläche der Elektroden 1 erzeugt. Diese negativen Ionen 7 werden durch eine elektrische Spannung von vorzugsweise mehr als hundert Volt in Richtung des Substrats 6 beschleunigt und dienen bei dem Verfahren vorteilhaft zur Modifizierung der Oberfläche des Substrats 6.

Es hat sich herausgestellt, dass die Bildung von negativen Ionen 7 auf der Oberfläche der Elektrode 1 dadurch begünstigt wird, dass die Elektroden 1 mit einem Mittelfrequenz-Spannungsgenerator 2 betrieben werden. Die Mittelfrequenz-Spannung hat eine Frequenz, die zwischen 1 kHz und 250 KHz liegt. Beispielsweise kann die Frequenz 100 kHz betragen.

Ein beispielhafter Verlauf der von dem Spannungsgenerator 2 erzeugten Entladungsspannung U in Abhängigkeit von der Zeit t ist in Figur 2 dargestellt. In einem ersten Zeitbereich 11 (der Aus-Phase) wird keine Spannung an die Elektroden 1 angelegt, wobei die Elektroden 1 in diesem Zeitbereich mit dem elektronegativen Bestandteil des Prozessgases 10, beispielsweise mit Sauerstoffatomen oder -molekülen, bedeckt werden. In einem zweiten Zeitbereich 12 (Zündungsphase) kommt es zu einer deutlichen Überhöhung der Spannung, was zur Entstehung von hochenergetischen Ionen mit Energien über 1000 eV führt. In einem dritten Zeitbereich 13, der so genannten Arbeitsphase, entsteht eine Entladungsspannung von mindestens 100 V, vorzugsweise mehreren hundert Volt, mit der die negativen Ionen 7 in Richtung des Substrats 6 beschleunigt werden.

Die von den in Richtung des Substrats 6 beschleunigten negativen Ionen 7 an der Oberfläche des Substrats 6 erzeugte Oberflächenstruktur hängt von den Dauern der einzelnen Zeitbereiche 11, 12, 13 ab und lässt sich daher insbesondere durch eine Variation der Pulsparameter der mit dem Spannungsgenerator 2 erzeugten Mittelfrequenz-Spannung beeinflussen. Der in Figur 2 dargestellte Verlauf der Spannung wurde unter Verwendung einer Aluminium-Elektrode 1 gemessen. Bei der Verwendung anderer Elektroden 1 ändert sich der prinzipielle Verlauf der Spannung nicht, jedoch die Höhe der Spannung und die Dauer der einzelnen Zeitbereiche 11, 12, 13, sodass sich durch die Verwendung verschiedener Elektroden verschiedenartige Strukturen an der Oberfläche des Substrats 6 erzeugen lassen.

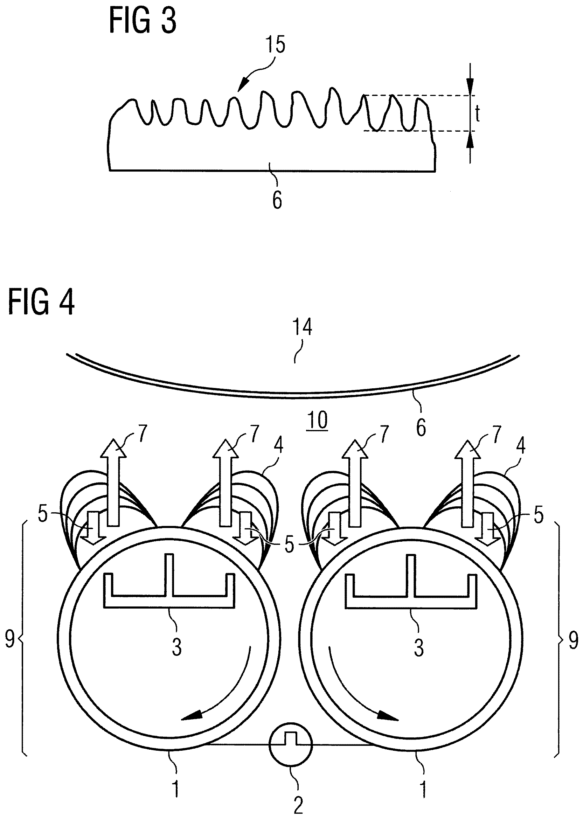

Bei dem Verfahren wird an der Oberfläche des Substrats 6 vorteilhaft eine Oberflächenstruktur 15 erzeugt, wie sie beispielhaft im Querschnitt in Figur 3 dargestellt ist. Die Oberflächenstruktur 15 erstreckt sich vorzugsweise bis in eine Tiefe t von mindestens 50 nm in das Substrat 6 hinein. Insbesondere wird durch die Oberflächenstruktur 15 an der Oberfläche des Substrats 6 ein Brechungsindexgradient ausgebildet. Dies bedeutet, dass der Brechungsindex an der Grenzfläche zwischen dem Substrat 6 und dem Umgebungsmedium aufgrund der Oberflächenstruktur 15 keine abrupte Änderung aufweist, sondern sich in der senkrecht zur Substratoberfläche verlaufenden Richtung kontinuierlich über einen Bereich ändert, welcher der Tiefe t der Oberflächenstruktur 15 entspricht. Durch einen derartigen Brechungsindexgradienten an der Oberfläche des Substrats 6 kann insbesondere die Reflexion der Oberfläche des Substrats 6 vermindert werden.

Das hierin beschriebene Verfahren hat den Vorteil, dass eine derartige Entspiegelung der Oberfläche eines Substrats 6 vergleichsweise schnell und kostengünstig, insbesondere auch auf großflächigen Substraten, erzielt werden kann. Beispielsweise konnte eine Senkung der Grenzflächenreflexion bei der Behandlung von Polyethylenterephthalat (PET) als Substratmaterial bereits nach einer Behandlungszeit von 30 Sekunden bei einer Bewegung des Substrats mit einer Durchlaufgeschwindigkeit von 0,5 m/min in einer Bandbeschichtungsanlage erreicht werden.

In Figur 4 ist ein weiteres Ausführungsbeispiel einer Vorrichtung zur Durchführung des Verfahrens schematisch im Querschnitt dargestellt. Im Gegensatz zu dem in Figur 1 dargestellten Ausführungsbeispiel werden zwei Rohrmagnetrons 9 zur Erzeugung der magnetfeldunterstützten Glimmentladung eingesetzt. Die Rohrmagnetrons 9 weisen jeweils Elektroden 1 in Form von zylinderförmigen Röhren auf, die während der Durchführung des Verfahrens vorzugsweise um ihre Hauptachse gedreht werden. Die Magnete 3 der Rohrmagnetrons 9 werden nicht bewegt und erzeugen somit jeweils ein stationäres Magnetfeld 4. Durch die Rotation der röhrenförmigen Elektroden 1 um ihre Hauptachse werden kontinuierlich neue Bereiche der Elektrodenoberflächen mit absorbierten Atomen oder Molekülen des elektronegativen Bestandteils des Prozessgases 10 in den Bereich der Magnetfelder 4 transportiert, in dem die magnetfeldunterstützte Glimmentladung stattfindet.

Bei dieser Ausführung werden daher besonders effektiv negative Ionen 7 an den Oberflächen der Elektroden 1 erzeugt, die in Richtung des Substrats 6 beschleunigt werden.

Weiterhin hat dieses Ausführungsbeispiel den Vorteil, dass die Anzahl der an den Elektrodenoberflächen 1 erzeugten negativen Ionen 7 durch eine Variation der Winkelgeschwindigkeit der Rotation der Elektroden 1 variiert werden kann und somit unabhängig vom Verlauf der Spannung eingestellt werden kann. Dies ermöglicht insbesondere den Einsatz eines vergleichsweise einfachen Spannungsgenerators 2, der beispielsweise einen sinusförmigen Verlauf der Entladungsspannung erzeugt.

Durch eine Änderung der Ausrichtung des von den Magneten 3 erzeugten Magnetfelds 4 kann die räumliche Verteilung der negativen Ionen 7 sowie deren Winkelverteilung eingestellt werden. Aufgrund der Rotation der röhrenförmigen Elektroden 1 werden die Oberflächen der Elektroden 1 gleichmäßig abgenutzt, sodass sich auch bei längerer Laufzeit der Elektroden 1 die räumliche Verteilung und die Winkelverteilung der negativen Ionen 7 nicht wesentlich ändern.

Durch die Verwendung mehrerer Rohrmagnetrons 9 kann die Durchlaufgeschwindigkeit eines bewegten Substrats 6 bei dem Ionenbeschuss erhöht werden. Beispielsweise konnte durch den gleichzeitigen Betrieb von vier Rohrmagnetrons 9 bei einer Durchlaufgeschwindigkeit von 2 m/min durch die Behandlung einer Seite eines PET-Substrats 6 eine Transmissionserhöhung von durchschnittlich 4 % im Vergleich zum unbehandelten Substrat erzielt werden.

## Patentansprüche

1. Verfahren zur Modifizierung einer Oberfläche eines Polymersubstrats (6) durch Ionenbeschuss, wobei
- die Ionen (7) mittels einer magnetfeldunterstützten Glimmentladung in einem Prozessgas (10) erzeugt werden,
- die magnetfeldunterstützte Glimmentladung mittels eines Magnetrons (8, 9) erzeugt wird, das eine Elektrode (1) und mindestens einen Magneten (3) zur Erzeugung des Magnetfelds (4) aufweist,
- das Prozessgas (10) mindestens einen elektronegativen Bestandteil aufweist, so dass bei der magnetfeldunterstützten Glimmentladung negative Ionen (7) erzeugt werden,
- die negativen Ionen (7), welche an der Oberfläche der Elektrode (1) erzeugt werden, durch eine an die Elektrode (1) angelegte elektrische Spannung in Richtung des Polymersubstrats (6) beschleunigt werden,
- die auf das Polymersubstrat (6) auftreffenden negativen Ionen (7) die Modifizierung der Oberfläche des Polymersubstrats (6) bewirken, und
- mittels des Ionenbeschusses eine Oberflächenstruktur (15) an der Oberfläche des Polymersubstrats (6) erzeugt wird, die sich mindestens 50 nm tief in das Polymersubstrat (6) hinein erstreckt, und
- die elektrische Spannung eine Frequenz zwischen 1 kHz und 250 kHz aufweist.

2. Verfahren nach Anspruch 1,
wobei der elektronegative Bestandteil des Prozessgases (10) Sauerstoff ist.

3. Verfahren nach Anspruch 1,
wobei der elektronegative Bestandteil des Prozessgases (10) Fluor oder Chlor ist.

4. Verfahren nach einem der vorhergehenden Ansprüche,
wobei die Elektrode (1) des Magnetrons (8, 9) mindestens eines der Elemente Al, Mg, Si oder Ti oder eine Legierung, die mindestens eines dieser Elemente mit einem Gewichtsanteil von mindestens 10% aufweist, enthält.

5. Verfahren nach einem der vorhergehenden Ansprüche,
wobei das Magnetron mindestens ein Planarmagnetron (8) aufweist.

6. Verfahren nach einem der vorhergehenden Ansprüche,
wobei das Magnetron mindestens ein Rohrmagnetron (9) aufweist.

7. Verfahren nach einem der vorhergehenden Ansprüche,
wobei an das Polymersubstrat keine Spannung angelegt wird.

8. Verfahren nach einem der vorhergehenden Ansprüche,
wobei das Polymersubstrat (6) Polyethylenterephthalat (PET), Polycarbonat (PC), Polymethylmethacrylat (PMMA), Ethylen-Tetrafluorethylen (ETFE), Polyethylennaphthalat (PEN) oder Triacetylcellulose (TAC) aufweist.

9. Verfahren nach einem der vorhergehenden Ansprüche,
wobei die Oberfläche des Polymersubstrats (6) nicht länger als 200 s mit den Ionen (7) bestrahlt wird.

10. Verfahren nach einem der vorhergehenden Ansprüche, bei dem das Polymersubstrat (6) während des Ionenbeschusses mit einer Geschwindigkeit von mindestens 1 m/min bewegt wird.

11. Verfahren nach einem der vorhergehenden Ansprüche,
wobei mittels des Ionenbeschusses eine Oberflächenstruktur (15) an der Oberfläche des Polymersubstrats (6) erzeugt wird, die einen Brechungsindexgradienten ausbildet.

12. Verfahren nach einem der vorhergehenden Ansprüche,
wobei eine mittels des Ionenbeschusses erzeugte Oberflächenstruktur (15) die Reflexion der Oberfläche des Polymersubstrats (6) vermindert.

## Claims

1. A method for modifying a surface of a polymer substrate (6) by ion bombardment, wherein
- the ions (7) are generated by means of a magnetic field-assisted glow discharge in a process gas (10),
- the magnetic field-assisted glow discharge is generated by means of a magnetron (8, 9) which comprises an electrode (1) and at least one magnet (3) for generating the magnetic field (4),
- the process gas (10) comprises at least one electronegative component, such that negative ions (7) are generated in the magnetic field-assisted glow discharge,
- the negative ions (7), which are generated at the surface of the electrode (1), are accelerated towards the polymer substrate (6) by an electrical voltage applied to the electrode (1),
- the negative ions (7) impinging on the polymer substrate (6) bring about the modification of the surface of the polymer substrate (6), and
- a surface texture (15) which extends to a depth of at least 50 nm into the polymer substrate (6) is produced on the surface of the polymer substrate (6) by means of the ion bombardment and
- the electrical voltage has a frequency of between 1 kHz and 250 kHz.

2. A method according to claim 1,
wherein the electronegative component of the process gas (10) is oxygen.

3. A method according to claim 1,
wherein the electronegative component of the process gas (10) is fluorine or chlorine.

4. A method according to one of the preceding claims,
wherein
the electrode (1) of the magnetron (8, 9) contains at least one of the elements Al, Mg, Si or Ti or an alloy which comprises at least one of these elements in a proportion by weight of at least 10%.

5. A method according to one of the preceding claims,
wherein the magnetron comprises at least one planar magnetron (8).

6. A method according to one of the preceding claims,
wherein the magnetron comprises at least one tube magnetron (9).

7. A method according to one of the preceding claims,
wherein no voltage is applied to the polymer substrate.

8. A method according to one of the preceding claims,
wherein the polymer substrate (6) comprises polyethylene terephthalate (PET), polycarbonate (PC), polymethyl methacrylate (PMMA), ethylene tetrafluoroethylene (ETFE), polyethylene naphthalate (PEN) or triacetyl cellulose (TAC).

9. A method according to one of the preceding claims,
wherein the surface of the polymer substrate (6) is irradiated with the ions (7) for no longer than 200 s.

10. A method according to one of the preceding claims, in which the polymer substrate (6) is moved at a speed of at least 1 m/min during ion bombardment.

11. A method according to one of the preceding claims,
wherein a surface texture (15) which brings about a refractive index gradient is produced on the surface of the polymer substrate (6) by means of the ion bombardment.

12. A method according to one of the preceding claims,
wherein a surface texture (15) produced by means of the ion bombardment reduces the reflectivity of the surface of the polymer substrate (6).

## Revendications

1. Procédé de modification d'une surface d'un substrat polymérique (6) par bombardement ionique, dans lequel
- les ions (7) sont générés dans un gaz de traitement (10) au moyen d'une décharge luminescente assistée par un champ magnétique,
- la décharge luminescente assistée par un champ magnétique est générée au moyen d'un magnétron (8, 9) présentant une électrode (1) et au moins un aimant (3) pour la génération du champ magnétique (4),
- le gaz de traitement (10) présente au moins une composante électronégative, de sorte que des ions négatifs (7) sont générés lors de la décharge luminescente assistée par un champ magnétique,
- les ions négatifs (7) générés à la surface de l'électrode (1) sont accélérés, par une tension électrique appliquée à l'électrode (1), en direction du substrat polymérique (6),
- les ions négatifs (7) entrant en contact avec le substrat polymérique (6) induisent la modification de la surface du substrat polymérique (6), et
- le bombardement ionique génère, à la surface du substrat polymérique (6), une structure de surface (15) s'étendant au moins selon une profondeur de 50 nm à l'intérieur du substrat polymérique (6), et
- la tension électrique présente une fréquence située entre 1 kHz et 250 kHz.

2. Procédé selon la revendication 1, dans lequel la composante électronégative du gaz de traitement (10) est l'oxygène.

3. Procédé selon la revendication 1, dans lequel la composante électronégative du gaz de traitement (10) est le fluor ou le chlore.

4. Procédé selon l'une des revendications précédentes, dans
lequel l'électrode (1) du magnétron (8, 9) contient au moins un des éléments parmi Al, Mg, Si ou Ti ou un alliage présentant au moins un de ces éléments selon un pourcentage en poids minimal de 10%.

5. Procédé selon l'une des revendications précédentes, dans
lequel le magnétron présente au moins un magnétron planaire (8).

6. Procédé selon l'une des revendications précédentes, dans
lequel le magnétron présente au moins un magnétron tubulaire (9).

7. Procédé selon l'une des revendications précédentes, dans
lequel aucune tension n'est appliquée au substrat polymérique.

8. Procédé selon l'une des revendications précédentes, dans
lequel le substrat polymérique (6) présente du polytéréphtalate d'éthylène (PET), du polycarbonate (PC), du polyméthacrylate de méthyle (PMMA), de l'éthylène-tétrafluoroéthylène (ETFE), du polynaphtalate d'éthylène (PEN) ou de la triacétylcellulose (TAC).

9. Procédé selon l'une des revendications précédentes, dans
lequel la surface du substrat polymérique (6) n'est pas bombardée par les ions (7) durant plus de 200 s.

10. Procédé selon l'une des revendications précédentes, dans
lequel le substrat polymérique (6) est déplacé selon une vitesse minimale de 1 m/min durant le bombardement ionique.

11. Procédé selon l'une des revendications précédentes, dans
lequel une structure de surface (15) constituant un gradient d'indice de réfraction est générée par le bombardement ionique sur la surface du substrat polymérique (6).

12. Procédé selon l'une des revendications précédentes, dans
lequel une structure de surface (15) du substrat polymérique (6) générée au moyen du bombardement ionique réduit la réflexion de la surface.
